# FASCICULE DE BREVET EUROPEEN

(11) **EP 0 407 957 B1**
(45) Date de publication et mention de la délivrance du brevet: **22.12.1993**
(21) Numéro de dépôt: 90113132.6
(22) Date de dépôt: 10.07.1990
(51) Int. Cl.: H05K 7/20

(54) **Dispositif de dissipation thermique pour composant de type cms monté sur plaque de circuit imprimé**
Wärmeabfuhrvorrichtung für Komponenten vom Typ SMD zur Montage auf Schaltplatten
Heat sink device for components of the SMD type mounted on a printed curcuit board

(30) Priorité: 10.07.1989 FR 8909246
(43) Date de publication de la demande: 16.01.1991
(73) Titulaire: ALCATEL BUSINESS SYSTEMS, F-75008 Paris (FR)
(72) Inventeur: Malaurie, Claude, F-95120 Ermont (FR); Bertet, Joel, F-78500 Sartrouville (FR)
(74) Mandataire: Weinmiller, Jürgen

(56) Documents cités:
- EP-A- 0 139 431
- DE-A- 3 128 856
- IBM Technical Disclosure Bulletin vol. 28, no. 11, avril 1986, pages 4723 - 4725; "Stiffened card with integrated circuit"

## Description

La présente invention se rapporte à un dispositif de dissipation thermique pour composant de type CMS ("Composant pour Montage en Surface") monté sur plaque de circuit imprimé, en particulier sur plaque de circuit imprimé équipant un poste téléphonique électronique.

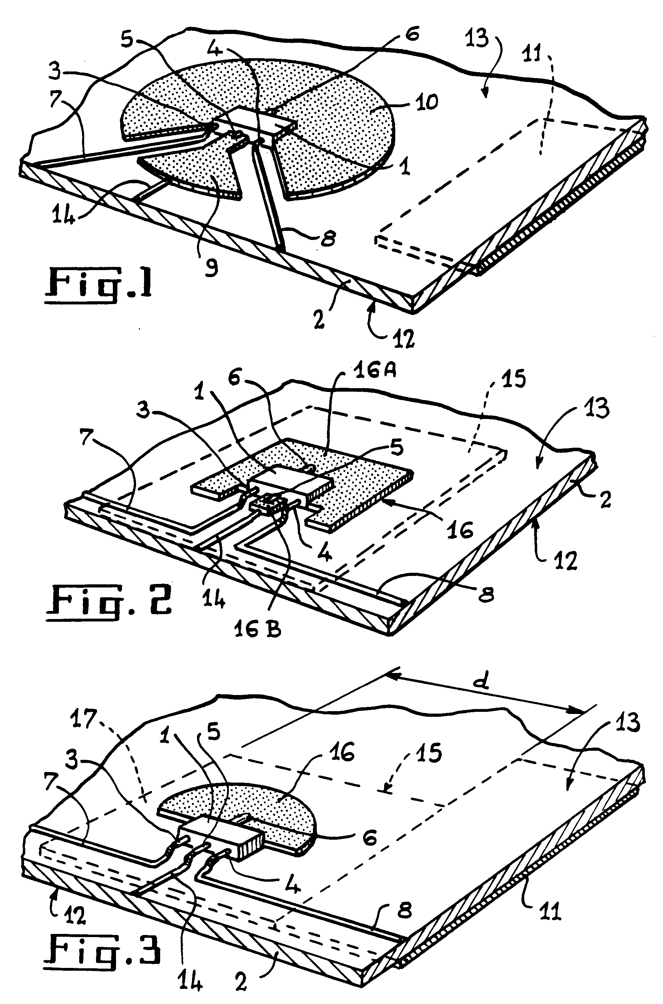

La figure 1 jointe est une illustration schématique de la technique actuelle. Il s'agit dans cet exemple d'un transistor 1, de type CMS, qui est monté sur un plaque de circuit imprimé 2, ou substrat, d'épaisseur classiquement de l'ordre de 1,5 millimètres, et qui possède une électrode d'émetteur 4, une électrode de base 3, et une électrode de collecteur qui, comme c'est en général le cas pour cette catégorie de composant CMS, se compose de deux bornes 5 et 6, distinctes mais électriquement reliées entre elles. Les électrodes d' émetteur 4 et de base 3 sont respectivement soudées sur deux pistes de connexion en Cuivre 8 et 7.

Afin de permettre l'évacuation thermique souhaitable, les deux bornes de collecteur 5 et 6 sont respectivement soudées sur deux surfaces dissipatrices en Cuivre 9 et 10, formant radiateurs, qui sont déposées sur le substrat isolant 2 et qui, dans cet exemple, adoptent dans leur ensemble la forme d'un disque plat de surface S. Au radiateur 9 est soudée la connexion de collecteur 14.

En outre, bien que ce ne soit pas toujours le cas, une feuille de cuivre 11 est déposée sur la majeure partie de la face 12 du substrat 2 qui est opposée à la face 13 qui reçoit tous les éléments électriques du circuit imprimé, tels que le transistor 1, les connexions 7, 8, 14, et le radiateur 9, 10. Cette feuille de cuivre 11, qui dans cet exemple ne s'étend pas jusque sous le transistor 1 et son radiateur 9, 10, est une plaque de blindage électromagnétique, fort utile en particulier dans le cas de circuits imprimés pour postes téléphoniques afin de s'affranchir des champs électromagnétiques émis ou reçus.

En outre, afin de favoriser, d'une manière générale, la dissipation de la chaleur interne des composants, il est courant d'augmenter dans la mesure du possible la largeur des pistes de connexion.

Ces procédés d'évacuation thermique connus ont pour inconvénient d'augmenter la surface occupée par les éléments électriques du circuit imprimé, et donc d'en accroître de manière dommageable l'encombrement et le prix de revient. Il est vrai que cette surface pourrait être réduite par l'utilisation de radiateurs collés sur les composants CMS, mais une telle solution serait coûteuse et très délicate de mise en oeuvre.

L'invention vise à remédier à ces inconvénients. Elle se rapporte à cet effet à un dispositif de dissipation thermique pour composant de type CMS monté sur plaque électriquement isolante de circuit imprimé (ou substrat), ce dispositif comprenant d'une part une première plaque métallique déposée sensiblement sous le composant CMS et sur la face du substrat opposée à celle qui reçoit ce composant, et d'autre part une autre plaque métallique le jouxtant ou l'entourant étroitement au moins partiellement, cette autre plaque métallique étant soudée à au moins une des bornes dissipatrices d'énergie thermique de ce composant CMS, étant déposée sur la même face du substrat que celle recevant ce composant CMS, étant au moins partiellement au droit d'au moins une fraction de ladite première plaque métallique, et étant de surface(s) égale à une fraction de la surface (S) de la plaque métallique qui conviendrait seule pour réaliser la même dissipation thermique si elle était classiquement déposée du même côté que ce composant CMS en entourant étroitement au moins partiellement celui-ci et en étant soudée à cette ou ces mêmes bornes dissipatrices d'énergie.

Préférentiellement, la surface (s) de cette autre plaque métallique est de l'ordre du quart de la surface (S) ci-dessus définie, pour un substrat courant d'épaisseur classiquement de l'ordre de 1,5 millimètres.

De toute façon, l'invention sera bien comprise, et ses avantages et autres caractéristiques ressortiront, lors de la description suivante de deux exemples non limitatifs de réalisation, en référence au dessin schématique annexé dans lequel :
- Figure 2 est une représentation schématique, en perspective partiellement écorchée, d'une première forme de réalisation de ce nouveau dispositif de dissipation thermique ; et
- Figure 3 représente de la même façon une deuxième forme de réalisation de ce même dispositif de dissipation thermique.

En se reportant tout d'abord à la figure 2, on reconnaît le substrat 2, d'épaisseur classiquement de l'ordre de 1,5 millimètres, et le transistor CMS 1, avec ses bornes d'émetteur et base, respectivement 4 et 3, et ses bornes de collecteur 5, 6 qui peuvent être considérées comme ses bornes dissipatrices de chaleur.
L'invention se base sur l'observation selon laquelle si la matière dont est classiquement constituée un substrat 2 pour plaque de circuit imprimé est étudiée pour être électriquement isolante, elle n'est en revanche pas du tout étudiée pour être thermiquement isolante, ce qui serait d'ailleurs beaucoup plus onéreux. Comme il s'agit par ailleurs de plaques d'assez faible épaisseur (1,5 millimètres en général), elles peuvent finalement être utilisées, bien que ce ne soit pas du tout leur but originel, comme organes de transmission thermique. Selon l'invention, la dissipation thermique est en fait réalisée par une relativement large plaque métallique 15 qui est déposée sur la plaque 2 de l'autre côté du transistor 1, c'est à dire sur la face 12, et la transmission à cette plaque 15 des calories du transistor et de ses bornes dissipatrices 5 et 6 est effectuée par l'intermédiaire d'un dispositif de couplage thermique qui se compose d'une part du substrat 2 lui-même et d'autre part d'une plaque collectrice de chaleur 16 qui entoure étroitement la quasi-totalité du transistor 1.

Cette plaque collectrice 16 est une plaque métallique qui est déposée sur la même face 13 du substrat 2 que le transistor 1 (alors que la plaque 15 est déposée sur la face opposée 12), et qui est en fait réalisée en deux parties 16A et 16B afin de laisser le passage pour les connexions 7 et 8. Sa surface totale (s) est égale à une fraction de la surface (S) précitée du radiateur plan (9, 10, figure 1) de la technique antérieure, et préférentiellement elle est de l'ordre du quart de cette surface (S).

La plaque métallique 15 peut aussi (à l'instar de la plaque 11 de la figure 1) avoir un rôle de blindage électromagnétique, et même être simplement constituée par la plaque de blindage électromagnétique déjà prévue pour ce circuit.

La réalisation de la figure 3 diffère de celle selon la figure 2 par le fait que la plaque collectrice 16 présente, à titre illustratif d'une autre forme de l'organe de couplage thermique, une forme de demi-cercle jouxtant un seul côté du transistor 1, mais soudée à sa borne collectrice 6, et par le fait que la plaque dissipatrice 15 est simplement constituée, par rapport à la réalisation selon la figure 1 qui comporte une plaque de blindage électromagnétique 11 qui n'est pas située sous le transistor 1, par une prolongation 17 de cette plaque de blindage 11 d'une longueur d suffisante pour que cette plaque de blindage 15 vienne s'étendre jusqu'en dessous du transistor 1 et de la plaque collectrice de chaleur 16.

Il est à noter, comme illustré sur les dessins, que les pistes de connexion 7, 8, 14, peuvent être moins larges que celles généralement prévues sur les circuits classiques tels que celui de la figure 1, sous réserve bien entendu qu'elles soient assez larges pour passer la densité de courant nécessaire.

Comme il va de soi, l'invention n'est pas limitée aux exemples de réalisation qui viennent d'être décrits. C'est ainsi que l'élément de couplage thermique 16 pourrait avoir une autre forme qu'une forme de rectangle (figure 2) ou une forme d'arc de cercle (figure 3). La plaque dissipatrice 15 elle-même est préférentiellement choisie très large, d'autant plus qu'elle a en outre le plus souvent un effet de blindage électromagnétique. Il n'empêche qu'elle pourrait très bien en s'attachant uniquement au point de vue de l'effet d'évacuation thermique, avoir des dimensions sensiblement égales à celles du radiateur 9, 10 (figure 1) de la technique antérieure, voire même inférieures à celles de ce dernier pourvu qu'elles soient suffisantes pour jouer le rôle de dissipation thermique. Par "plaque métallique", on entend une plaque constituée en métal proprement dit, ou bien entendu en tout autre matériau équivalent du point de vue de ses propriétés de conduction thermique.

## Revendications

1. Dispositif de dissipation thermique pour composant de type CMS (1) monté sur plaque de circuit imprimé (2), ou substrat, ce dispositif comportant :
. d'une part une première plaque métallique (15) déposée sensiblement sous le composant CMS (1) et sur la face (12) du substrat (2) qui est opposée à celle (13) qui reçoit ce composant (1), et
. d'autre part une autre plaque métallique (16) jouxtant ou entourant étroitement au moins partiellement ce même composant (1), cette autre plaque métallique (16) étant soudée à au moins une des bornes (5, 6) dissipatrices d'énergie de ce composant CMS (1), étant déposée sur la face (13) du substrat (2) qui reçoit ce composant (1), étant au moins partiellement au droit d'au moins une fraction de ladite première plaque métallique (15), et étant de surface totale (s) égale à une fraction de la surface totale (S) de la plaque métallique (9, 10) qui conviendrait seule pour effectuer la même dissipation thermique si elle était classiquement déposée du même côté (13) que ce composant CMS (1) en l'entourant étroitement au moins partiellement et en étant soudée à cette ou ces mêmes bornes dissipatrices d'énergie (5, 6).

2. Dispositif de dissipation thermique selon la revendication 1, caractérisé en ce que, s'agissant d'un substrat (2) courant, dont l'épaisseur est classiquement de l'ordre de 1,5 millimètres, la surface totale (s) de cette autre plaque métallique (16) est de l'ordre du quart de la surface totale (S) de ladite plaque métallique (9, 10) qui conviendrait seule pour effectuer la même dissipation thermique si elle était classiquement déposée du même côté (13) que ce composant CMS (1).

3. Dispositif de dissipation thermique selon l'une des revendications 1 ou 2, caractérisé en ce que cette première plaque métallique (15) est choisie suffisamment large pour jouer en outre un rôle de blindage électromagnétique.

4. Dispositif de dissipation thermique selon la revendication 3, caractérisé en ce que cette première plaque métallique (15) est tout simplement constituée par la plaque de blindage électromagnétique normalement prévue sur cette face (12) du substrat opposée à celle (13) recevant le composant CMS (1).

5. Dispositif de dissipation thermique selon la revendication 3, caractérisé en ce que cette première plaque métallique est réalisée par une prolongation (17) de la plaque de blindage électromagnétique (11) normalement prévue sur la face (12) du substrat opposée à celle (13) recevant ce composant CMS (1), dans le cas où cette plaque de blindage (11) n'est normalement pas prévue pour s'étendre jusque sous ce composant CMS (1).

## Patentansprüche

1. Vorrichtung zur Wärmeabfuhr von einem auf eine Druckschaltungsplatte (2) oder ein Substrat aufgebrachten Bauteil (1), wobei die Vorrichtung
. einerseits eine erste Metallplatte (15), die im wesentlichen unter dem Bauteil (1) und auf der Seite (12) des Substrats (2) angebracht ist, die derjenigen (13) gegenüberliegt, auf der das Bauteil (1) sitzt,
. und andererseits eine weitere Metallplatte (16) enthält, die am Bauteil (1) anliegt oder dieses zumindest teilweise eng umgibt, wobei diese weitere Metallplatte (16) an mindestens eine der Wärmeenergie abführenden Klemmen (5, 6) dieses Bauteils (1) angelötet ist, auf die Seite (13) des Substrats (2) aufgebracht ist, auf der das Bauteil (1) sitzt, mindestens teilweise mindestens einem Teil der ersten Platte (15) gegenüberliegt und eine Gesamtoberfläche (s) besitzt, die einen Bruchteil der Gesamtoberfläche (S) der Metallplatte (9, 10) beträgt, welche alleine die gleiche Wärmeabfuhr bewirken würde, wenn sie wie üblich auf derselben Seite (13) wie das Bauteil (1) aufgebracht wäre und zumindest teilweise das Bauteil eng umgeben würde sowie an die Wärmeabfuhrklemme(n) (5, 6) angeschlossen wären.

2. Vorrichtung zur Wärmeabfuhr nach Anspruch 1, dadurch gekennzeichnet, daß im Fall eines üblichen Substrats (2), dessen Dicke üblicherweise etwa 1,5 mm beträgt, die Gesamtoberfläche (s) dieser weiteren Metallplatte (16) größenordnungsmäßig ein Viertel der Gesamtoberfläche (S) der Metallplatte (9, 10) mißt, die alleine für dieselbe Wärmeabfuhr geeignet wäre, wenn sie wie üblich auf derselben Seite (13) wie das Bauteil (1) aufgebracht wäre.

3. Wärmeabfuhrvorrichtung nach einem der Ansprüche 1 oder 2, dadurch gekennzeichnet, daß die erste Metallplatte (15) ausreichend breit gewählt wird, um außerdem eine elektromagnetische Abschirmung zu bewirken.

4. Wärmeabfuhrvorrichtung nach Anspruch 3, dadurch gekennzeichnet, daß die erste Platte (15) ganz einfach aus der elektromagnetischen Abschirmplatte besteht, die normalerweise auf der Seite (12) des Substrats vorgesehen ist, die der das Bauteil (1) tragenden Seite (13) gegenüberliegt.

5. Vorrichtung zur Wärmeabfuhr nach Anspruch 3, dadurch gekennzeichnet, daß die erste Metallplatte aus einer Verlängerung (17) der elektromagnetischen Abschirmplatte (11) gebildet wird, die normalerweise auf der Seite (12) des Substrats vorgesehen ist, die derjenigen (13) gegenüberliegt, auf der das Bauteil (1) sitzt, und zwar für den Fall, daß diese Abschirmplatte (11) normalerweise nicht bis unter das Bauteil (1) reichen würde.

## Claims

1. Heat sink device for a surface mount component (1) mounted on a printed circuit board (2) or substrate, said device including:
- firstly, a first metallic plate (15) deposited substantially under the surface mount component (1) and on the side (12) of the substrate (2) opposing the side (13) which receives said component (1), and
- secondly, a further metallic plate (16) in juxtaposition with or closely surrounding at least partially said component (1), said further metallic plate (16) being soldered to at least one of the thermal dissipation leads (5, 6) of the surface mount component (1), deposited on the side (13) of the substrate (2) that receives said component (1), at least partially under the projection of at least a portion of said first metallic plate (15), and having a total surface area (s) which is equal to a fraction of the total surface area (S) of the metal plate (9, 10) which, alone, would be suitable to perform the same amount of thermal dissipation if it were conventionally deposited on the same side as the surface mount component (1) in an at least partial close surrounding relation thereto and were soldered to this same or these same thermal dissipation leads (5, 6).

2. Heat sink device according to claim 1, characterized in that, with the use of an ordinary standard substrate (2) having a thickness which conventionally is of the order of 1.5 mm, the total surface are (s) of this further metallic plate (16) is of the order of one-quarter of the total surface area (S) of said metallic plate (9, 10) which, alone, would be suitable to obtain the same thermal dissipation if it were conventionally deposited on the same side as the surface mount component (1).

3. Heat sink device according to claim 1 or 2, characterized in that said first metallic plate (15) is selected to be sufficiently wide to further perform the function of an electromagnetic shield.

4. Heat sink device according to claim 3, characterized in that said first metallic plate (15) is simply constituted by the electromagnetic shielding plate that is normally provided on this side (12) of the substrate opposite the side (13) that receives the surface mount component (1).

5. Heat sink device according to claim 3, characterized in that said first metallic plate takes the form of an extension (17) of the electromagnetic shielding plate (11) normally provided on the side (12) of the substrate opposite the side (13) that receives the surface mount component (1), in case this shielding plate (11) were not normally intended to extend right under the surface mount component (1).
